# EUROPEAN PATENT APPLICATION

(11) **EP 2 662 882 A1**
(43) Date of publication of application: **13.11.2013**
(21) Application number: 12785747.2
(22) Date of filing: 10.05.2012
(51) Int. Cl.: H01L 21/20, H01L 21/205, H01L 21/338, H01L 29/778, H01L 29/812

(54) **SEMICONDUCTOR ELEMENT AND METHOD FOR PRODUCING SAME**

(30) Priority: 17.05.2011 JP 2011110689
(71) Applicant: Advanced Power Device Research Association, Yokohama-shi, Kanagawa 220-0073 (JP)
(72) Inventor: KOKAWA, Takuya, Yokohama-shi Kanagawa 220-0073 (JP); KATOU, Sadahiro, Yokohama-shi Kanagawa 220-0073 (JP); IWAMI, Masayuki, Yokohama-shi Kanagawa 220-0073 (JP); UTSUMI, Makoto, Yokohama-shi Kanagawa 220-0073 (JP)
(74) Representative: Horn Kleimann Waitzhofer
(86) International application number: PCT/JP2012/003076
(87) International publication number: WO 2012/157228

(57) **Abstract**

Provided is a semiconductor device that has a buffer layer with which a dislocation density is decreased. The semiconductor device includes a substrate, a buffer region formed over the substrate, an active layer formed on the buffer region, and at least two electrodes formed on the active layer. The buffer region includes at least one composite layer in which a first semiconductor layer having a first lattice constant, a second semiconductor layer having a second lattice constant that is different from the first lattice constant and formed in contact with the first semiconductor layer, and a third semiconductor layer having a third lattice constant that is between the first lattice constant and the second lattice constant are sequentially stacked.

## Description

### BACKGROUND

### 1. TECHNICAL FIELD

The present invention relates to a semiconductor device and a method of manufacturing a semiconductor device. More specifically, the present invention relates to a semiconductor device having a buffer layer that reduces a dislocation density, and a manufacturing method thereof.

### 2. RELATED ART

A semiconductor device having a buffer region and a nitride-based semiconductor region disposed over the buffer region has been known. The buffer region includes AlN layers and GaN layers alternatively deposited on a silicon substrate has been known. Such buffer region reduces a difference in lattice constant or thermal expansion coefficient between the silicon substrate and the nitride-based semiconductor region, and mitigates chances of cracks and dislocations. (For example, see Patent Documents 1 to 3.) The above-mentioned Patent Document 1 is Japanese Patent Application Publication 2003-59948, Patent Document 2 is Japanese Patent Application Publication 2007-88426, and Patent Document 3 is Japanese Patent Application Publication 2009-289956.

However, conventional solutions can increase a withstand voltage by increasing the thickness but cannot reduce a dislocation density sufficiently.

### SUMMARY

Therefore, it is an object of an aspect of the innovations herein to provide a semiconductor device and a method of manufacturing the same, which are capable of overcoming the above drawbacks accompanying the related art. The above and other objects can be achieved by combinations described in the claims. A first aspect of the innovations may include a semiconductor device that includes a substrate, a buffer region formed over the substrate, an active layer formed on the buffer region, and at least two electrodes formed on the active layer. The buffer region includes at least one composite layer in which a first semiconductor layer having a first lattice constant, a second semiconductor layer having a second lattice constant that is different from the first lattice constant and formed in contact with the first semiconductor layer, and a third semiconductor layer having a third lattice constant that is between the first lattice constant and the second lattice constant are sequentially stacked. The first semiconductor layer or the active layer is formed on and in contact with each third semiconductor layer.

A second aspect of the innovations may include a method of manufacturing a semiconductor device. The method includes providing a substrate, forming a buffer region over the substrate, forming an active layer on the buffer region, forming at least two electrodes on the active layer. The forming the buffer region includes repeating at least one cycle that includes forming a first semiconductor layer with a first lattice constant, forming a second semiconductor layer with a second lattice constant that is smaller than the first lattice constant in contact with the first semiconductor layer, and then forming a third semiconductor layer with a third lattice constant that is between the first lattice constant and the second lattice constant. The first semiconductor layer or the active layer is formed on and in contact with each third semiconductor layer.

The summary clause does not necessarily describe all necessary features of the embodiments of the present invention. The present invention may also be a sub-combination of the features described above.

### BRIEF DESCRIPTION OF THE DRAWINGS

Fig. 1 is a sectional view of a semiconductor device according to a first embodiment of the present invention.
Fig. 2 illustrates a change in Al composition ratio in a thickness direction of a buffer region of the semiconductor device of Fig. 1.
Fig. 3 shows results of experiments to compare the roughness of the top surface of a buffer region in cases where the buffer region have different configurations A, B, C, and D.
Fig. 4 illustrates another example of a change in the Al composition ratio in the buffer region of the semiconductor device of Fig. 1.
Fig. 5 illustrates another example of a change in the Al composition ratio in the buffer region of the semiconductor device of Fig. 1.
Fig. 6 illustrates another example of a change in the Al composition ratio in the buffer region of the semiconductor device of Fig. 1.
Fig. 7 illustrates another example of a change in the Al composition ratio in the buffer region of the semiconductor device of Fig. 1.
Fig. 8 illustrates another example of a change in the Al composition ratio in the buffer region of the semiconductor device of Fig. 1.
Fig. 9 illustrates another example of a change in the Al composition ratio in the buffer region of the semiconductor device of Fig. 1.
Fig. 10 illustrates another example of a change in the Al composition ratio in the buffer region of the semiconductor device of Fig. 1.
Fig. 11 is a sectional view of a semiconductor device according to a second embodiment of the invention.
Fig. 12 illustrates a change in an Al composition ratio in a thickness direction of a buffer region of the semiconductor device of Fig. 11.
Fig. 13 illustrates another example of a change in the Al composition ratio in the thickness direction of the buffer region of the semiconductor device of Fig. 11.
Fig. 14 illustrates another example of a change in the Al composition ratio in the thickness direction of the buffer region of the semiconductor device of Fig. 11.
Fig. 15 illustrates another example of a change in the Al composition ratio in the thickness direction of the buffer region of the semiconductor device of Fig. 11.
Fig. 16 illustrates another example of a change in the Al composition ratio in the thickness direction of the buffer region of the semiconductor device of Fig. 11.
Fig. 17 illustrates another example of a change in the Al composition ratio in the thickness direction of the buffer region of the semiconductor device of Fig. 11.
Fig. 18 illustrates another example of a change in the Al composition ratio in the thickness direction of the buffer region of the semiconductor device of Fig. 11.
Fig. 19 illustrates another example of a change in the Al composition ratio in the thickness direction of the buffer region of the semiconductor device of Fig. 11.
Fig. 20 illustrates another example of a change in the Al composition ratio in the thickness direction of the buffer region of the semiconductor device of Fig. 11.
Fig. 21 illustrates another example of a change in the Al composition ratio in the thickness direction of the buffer region of the semiconductor device of Fig. 11.
Fig. 22 illustrates another example of a change in the Al composition ratio in the thickness direction of the buffer region of the semiconductor device of Fig. 11.
Fig. 23 illustrates another example of a change in the Al composition ratio in the thickness direction of the buffer region of the semiconductor device of Fig. 11.
Fig. 24 illustrates layer thicknesses of a third semiconductor layer and a fourth semiconductor layer in each composite layer of the semiconductor device of Fig. 11.
Fig. 25 illustrates relationship between a dislocation density and the number of composite layers in the buffer region of the semiconductor element of Fig. 11.
Fig. 26 illustrates relationships between a dislocation density and the thicknesses of the third semiconductor layer and the fourth semiconductor layer in the buffer region of the semiconductor element of Fig. 11.
Fig. 27 illustrates relationships between the dislocation density and the largest Al composition ratios in the second, third and fourth semiconductor layers in the buffer region of the semiconductor element of Fig. 11.
Fig. 28 illustrates relationship between a dislocation density and a C doping concentration in the second semiconductor layer in the buffer region of the semiconductor element of Fig. 11.
Fig. 29 illustrates relationship between a dislocation density and a C doping concentration in the first semiconductor layer in the buffer region of the semiconductor device of Fig. 11.
Fig. 30 illustrates relationship between a dislocation density and a layer thickness of an Al 25% region in the top third semiconductor layer in the buffer region of the semiconductor device of Fig. 11.
Fig. 31 illustrates Modification Examples 1 to 5 of the semiconductor device of Fig. 11 in which the layer thickness of the first semiconductor layer and the number of composition layers in the buffer region are varied.
Fig. 32 illustrates measurement results of the amount of warpage and the dislocation density in Modification Examples 1 to 5 shown in Fig. 31.

### DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means provided by aspects of the invention.

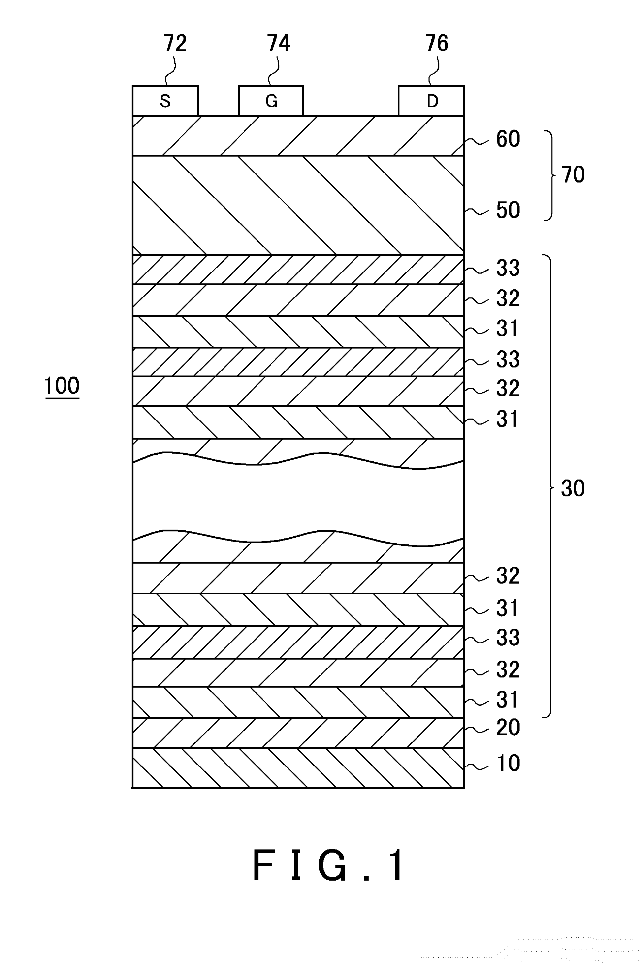

Fig. 1 is a sectional view of a semiconductor device 100 according to the first embodiment of the present invention. While an HEMT will be hereunder described as an example of the semiconductor device 100, the semiconductor device is not limited to this. The semiconductor device 100 includes a substrate 10, an interlayer 20, a buffer region 30 formed over the substrate 10, an active layer 70 formed on the buffer region 30, and at least two electrodes (a source electrode 72, a gate electrode 74, and a drain electrode 76 in this example) formed on the active layer 70.

The substrate 10 serves as a supporting member for the buffer region 30 and the active layer 70. The substrate 10 may be a silicon monocrystal substrate with a main surface of the (111) plane. The main surface here refers to a surface where the buffer region 30 and the active layer 70 are deposited.

The interlayer 20 serves as an alloy inhibition layer that prevents chemical reaction between the substrate 10 and the buffer region 30. The interlayer 20 is made of, for example, an undoped AlN. The lattice constant of the interlayer 20 may be smaller than that of the substrate 10. The coefficient of thermal expansion of the interlayer 20 may be larger than that of the substrate 10. When the substrate 10 is a silicon substrate, the lattice constant is 0.384 nm, and the coefficient of thermal expansion is 3.59×10⁻⁶/K. When the interlayer 20 is made of AlN, the lattice constant of the interlayer 20 is 0.3112 nm, and the coefficient of thermal expansion is 4.2×10⁻⁶/K. The thickness of the interlayer 20 is, for example, 40 nm.

The buffer region 30 includes at least one composite layer in which a first semiconductor layer 31 with a first lattice constant, a second semiconductor layer 32 with a second lattice constant, and a third semiconductor layer 33 with a third lattice constant are sequentially stacked in the stated order. The second lattice constant is different from the first lattice constant.

The first semiconductor layer 31 is formed on the interlayer 20. The first semiconductor layer 31 may have the first lattice constant that is smaller than the lattice constant of the substrate 10. The semiconductor layer 31 may have a larger coefficient of thermal expansion than that of the substrate 10. The first semiconductor layer 31 includes Alₓ₁In_{y1}Ga₁-ₓ₁-_{y1}N (where 0 ≤ x1 < 1, 0 ≤ y1 ≤ 1, x1+y1 ≤ 1). The first semiconductor layer 31 is made of, for example, GaN. In this case, the first lattice constant of the first semiconductor layer 31 is 0.3189 nm, and the coefficient of thermal expansion is 5.59×10⁻⁶/K.

The second semiconductor layer 32 is formed on and in contact with the first semiconductor layer 31. The second semiconductor layer 32 may have the second lattice constant that is smaller than the first semiconductor layer 31. The second semiconductor layer 32 may have a larger coefficient of thermal expansion than that of the substrate 10. The second semiconductor layer 32 includes Alₓ₂In_{y2}Ga₁-ₓ₂-_{y2}N (where 0 < x2 ≤ 1, 0 ≤ y2 ≤ 1, x2+y2 ≤ 1). The second semiconductor layer 32 is made of, for example, AlN. In this case, the second lattice constant of the second semiconductor layer 32 is 0.3112 nm, and the coefficient of thermal expansion is 4.2×10⁻⁶/K.

The third semiconductor layer 33 is formed on and in contact with the second semiconductor layer 32. The third semiconductor layer 33 has the third lattice constant that is between the first lattice constant and the second lattice constant. The third semiconductor layer 33 has a coefficient of thermal expansion between those of the first semiconductor layer 31 and the second semiconductor layer 32. The third semiconductor layer 33 includes Alₓ₃In_{y3}Ga₁-ₓ₃-_{y3}N (where 0 < x3 < 1, 0 ≤ y3 ≤ 1, x3+y3 ≤ 1). The third semiconductor layer 33 is made of, for example, AlGaN.

The third semiconductor layer 33 has a lattice constant and a coefficient of thermal expansion that is between those of GaN and AlN, and corresponds to the Al composition ratio. The lattice constant of the third semiconductor layer 33 decreases from a point of the layer nearest to the substrate 10 to a point of the layer farthest from the substrate 10. In other words, the Al ratio in the third semiconductor layer 33 increases from the closest to the farthest to the substrate 10. The first to third semiconductor layers 31 to 33 have a relation in the Al composition, x1 < x3 ≤ x2.

The buffer region 30 relaxes strain generated from differences in the lattice constant and the coefficient of thermal expansion between the substrate 10 and the active layer 70, and restrains a threading dislocation density. The buffer region 30 has, for example, twelve composite layers in which the first semiconductor layer 31, the second semiconductor layer 32, and the third semiconductor layer 33 are sequentially deposited. The thicknesses of the first semiconductor layers 31 are, for example, 70 nm, 90 nm, 120 nm, 150 nm, 190 nm, 240 nm, 300 nm, 370 nm, 470 nm, 600 nm, 790 nm, and 1040 nm respectively stated from the one closest to the substrate 10. The thicknesses of the second semiconductor layers 32 may be constant and may be, for example, 60 nm. The thicknesses of the third semiconductor layers 33 may be constant and may be, for example, 60 nm.

The active layer 70 has an electron transit layer 50, and an electron supply layer 60. The electron transit layer 50 is formed in contact with the third semiconductor layer 33 that is the top layer in the buffer region 30. The electron transit layer 50 generates a low-resistivity two-dimensional electron gas at a heterojunction interface with the electron supply layer 60. The electron transit layer 50 may include undoped GaN. The electron transit layer 50 has a thickness of, for example, 1200 nm. The electron supply layer 60 is formed in contact with the electron transit layer 50. The electron supply layer 60 supplies electrons to the electron transit layer 50. The electron supply layer 60 includes, for example, AlGaN doped with an n-type impurity such as Si. The electron supply layer 60 has a thickness of, for example, 25 nm.

The at least two electrodes may include the source electrode 72, the gate electrode 74, and the drain electrode 76. The source electrode 72 and the drain electrode 76 may have a layered structure of Ti/Al that is in ohmic contact with the electron supply layer 60. The gate electrode 74 may have a layered structure of Pt/Au that is in schottky contact with the electron supply layer 60.

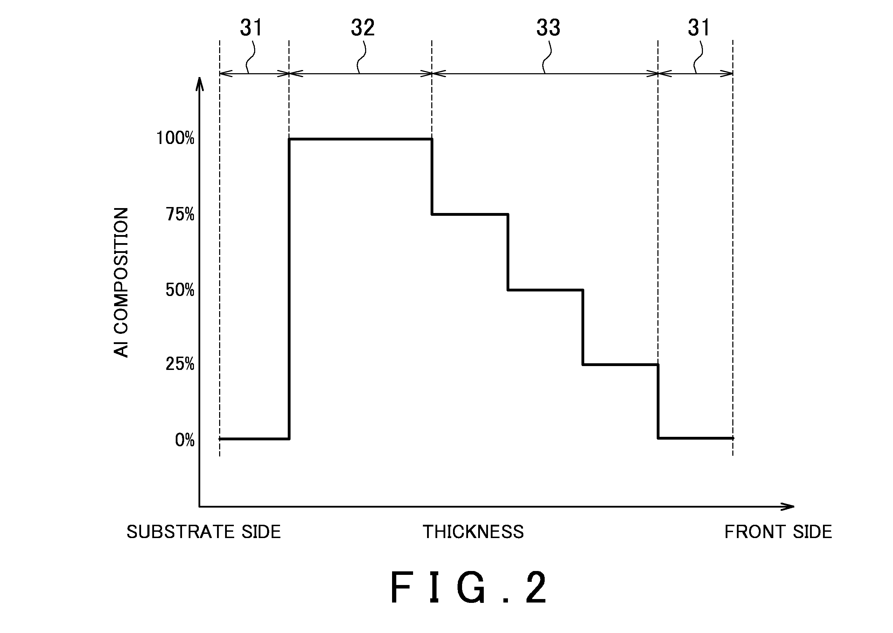

Fig. 2 illustrates a change in Al composition ratio in the thickness direction of the buffer region 30. Here, the Al ratio in the first semiconductor layer 31 is 0%, and the Al ratio in the second semiconductor layer 32 is 100%. However, the Al ratios are not limited to this. The Al composition ratio in the third semiconductor layer 33 decreases in a stepwise fashion from the second semiconductor layer 32 to the first semiconductor layer 31.

The Al composition ratio in the third semiconductor layer 33 decreases by a step of 25% from the second semiconductor layer 32. The thickness of the third semiconductor layer 33 is constant in each step, for example, the thickness is 20 nm, but it may be different for each step. The third semiconductor layer 33 may be doped with an impurity. The impurity may be carbon C. The third semiconductor layer 33 is doped with C at a concentration of, for example, 1E19 cm⁻³. Leakage current in the semiconductor device 100 can be reduced by doping the layer with C.

In the example shown in Fig. 2, the dislocation generated in the first semiconductor layer 31 once increases due to the difference in the lattice constant between the first semiconductor layer and the second semiconductor layer 32. However, the Al proportion in the third semiconductor layer 33 decreases in a stepwise fashion as the distance from the substrate 10 increases, and therefore the lattice constant and the coefficient of thermal expansion change gradually and the strain is relaxed. As a result, the dislocation density in the third semiconductor layer 33 decreases. By providing more the composite layers in which the first semiconductor layer 31, the second semiconductor layer 32, and the third semiconductor layer 33 are sequentially deposited, the threading dislocation density is decreased. Moreover, because the first semiconductor layers 31 are formed such that the thicknesses are gradually increased, it is possible to increase the total thickness while warpage is accommodated. Consequently, it is possible to increase the withstand voltage of the semiconductor device 100.

A silicon (111) substrate with a diameter of about 10 cm was used as the substrate 10, and the dislocation density was measured by X-ray diffractometry. The measurement result of the dislocation density of the epitaxial substrate on which the buffer region 30 illustrated in Fig. 2 was formed was about 5E9 cm⁻². Whereas the dislocation density of the epitaxial substrate on which a buffer region that does not include the third semiconductor layer 33 but only include a GaN/AlN layered structure was about 1E11 cm⁻². Therefore, it is effective to provide the third semiconductor layer 33 in order to reduce the dislocation density.

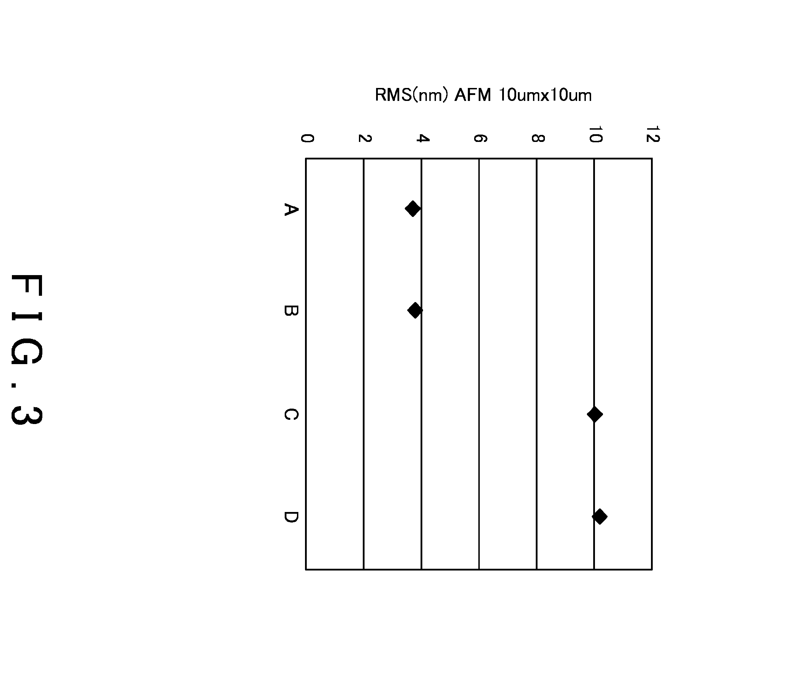

Fig. 3 shows results of experiments to compare the roughness of the top surface of the buffer region 30 in cases where the buffer region 30 has different configurations A, B, C, and D. Configuration A has a buffer structure in which GaN/AlN is repeatedly deposited. Configuration B has a buffer structure in which GaN/AlN/AlGaN is repeatedly deposited. Configuration C has a buffer structure in which GaN/AlGaN/AlN is repeatedly deposited. Configuration D has a buffer structure in which GaN/AlGaN/AlN/AlGaN is repeatedly deposited. In Configurations B, C, and D, the AlGaN layer has the Al composition ratio in which the Al proportion increases by a step of 25%, and the AlGaN layer ahs a thickness of 60 nm. The surface roughness in the range of 10 µm × 10 µm was evaluated by measuring a root mean square (RMS) roughness with an atomic force microscope (AFM).

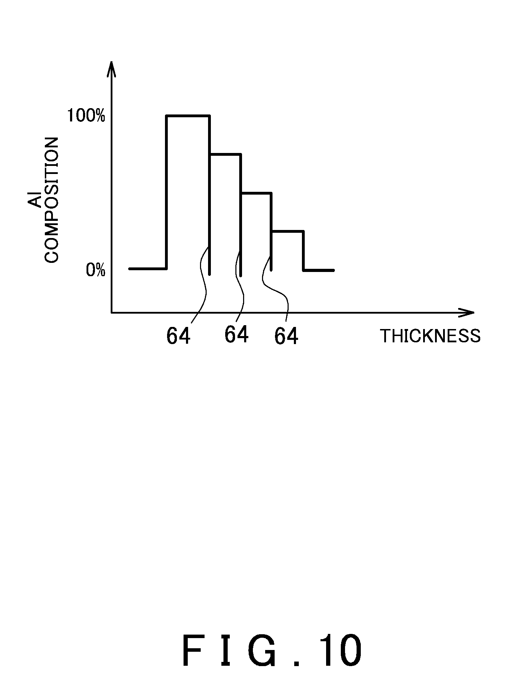

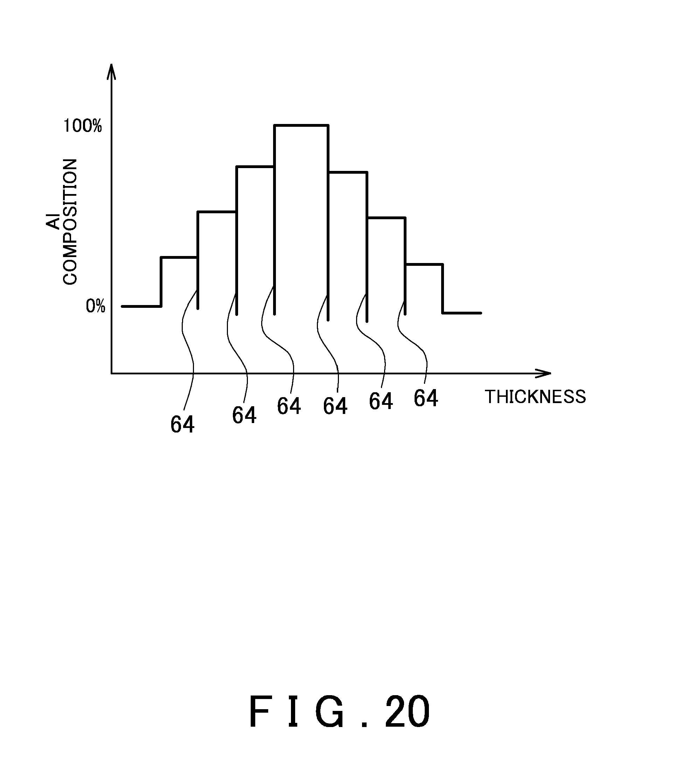

Referring to Fig. 3, Configuration A and Configuration B have the substantially same surface roughness, and Configuration C and Configuration D have the substantially same surface roughness. It is also understood from the drawing that the surface roughness in Configuration C and Configuration D is larger than that of Configuration A and Configuration B. From such results, it is understood that the surface roughness of the buffer region is increased when the AlGaN layer is formed under the AlN layer or the AlGaN layer is formed on and under the AlN layer. Moreover, referring to Fig. 10 and Fig. 20, the crystallinity can be improved by interposing the GaN layer with the thickness of about 1nm in the AlGaN layer, and consequently the surface roughness can be reduced.

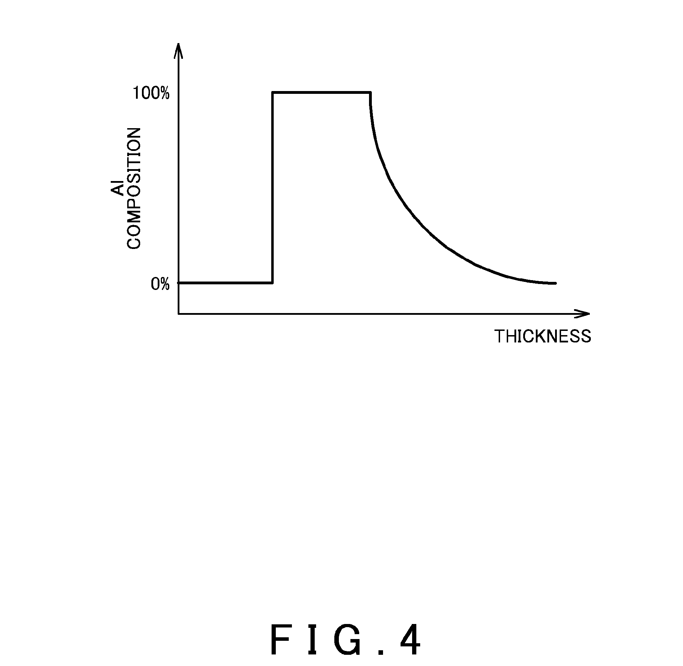

Fig. 4 illustrates another example of a change in the Al composition ratio in the third semiconductor layer 33. The Al composition ratio decreases in a curved pattern from the second semiconductor layer 32 to the first semiconductor layer 31. The rate of decrease of the Al composition ratio is larger as it gets closer to the second semiconductor layer 32. When the third semiconductor layer 33 is configured in this way, it is also possible to reduce the dislocation density of the semiconductor device 100.

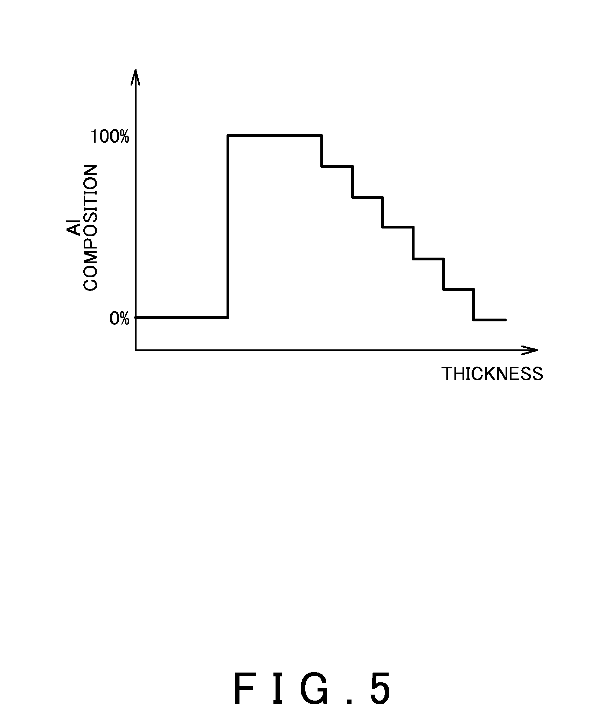

Fig. 5 illustrates another example of a change in the Al composition ratio in the third semiconductor layer 33. The Al composition ratio decreases by a step of 5% from the second semiconductor layer 32 to the first semiconductor layer 31. When the third semiconductor layer 33 is configured in this way, it is also possible to reduce the dislocation density of the semiconductor device 100.

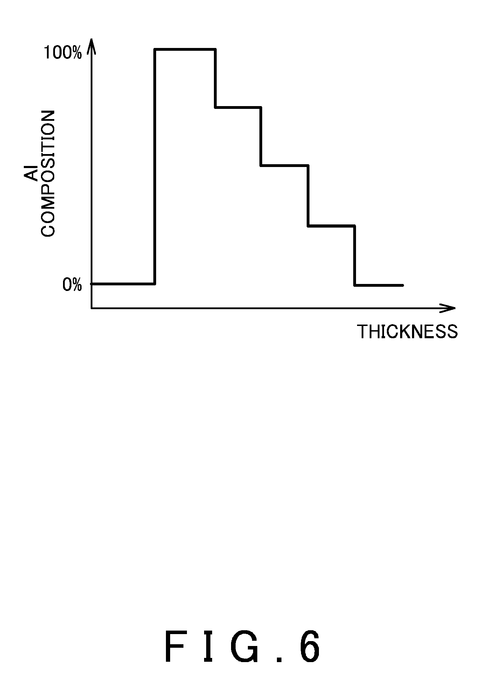

Fig. 6 illustrates another example of a change in the Al composition ratio in the third semiconductor layer 33. The Al ratio linearly decreases from the second semiconductor layer 32 to the first semiconductor layer 31. When the third semiconductor layer 33 is configured in this way, it is also possible to reduce the dislocation density of the semiconductor device 100.

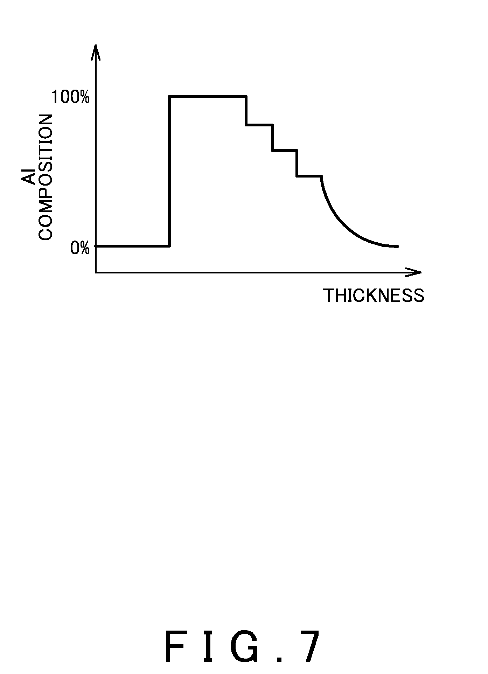

Fig. 7 illustrates another example of a change in the Al composition ratio in the third semiconductor layer 33. The Al composition ratio decreases by a step of 5% from the second semiconductor layer 32 to the half way to the first semiconductor layer 31, then decreases in a curved pattern. In the region where the Al composition ratio changes in the curved pattern, the rate of decrease of the Al composition ratio is larger as it is closer to the second semiconductor layer 32. When the third semiconductor layer 33 is configured in this way, it is also possible to reduce the dislocation density of the semiconductor device 100.

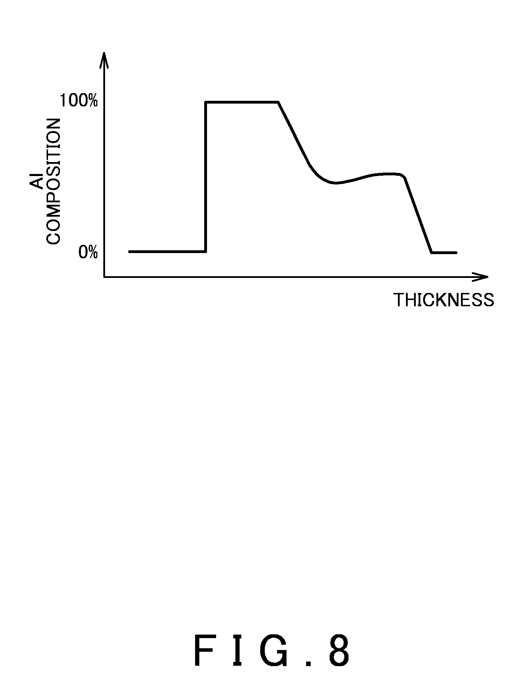

Fig. 8 illustrates another example of a change in the Al composition ratio in the third semiconductor layer 33. The Al composition ratio lineally decreases from the second semiconductor layer 32 to the half way to the first semiconductor layer 31, subsequently the Al composition ratio once increases and then lineally decreases again. When the third semiconductor layer 33 is configured in this way, it is also possible to reduce the dislocation density of the semiconductor device 100.

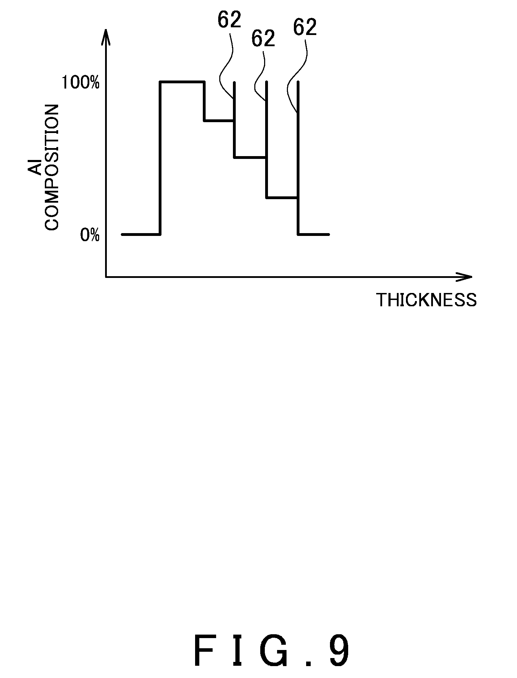

Fig. 9 illustrates another example of a change in the Al composition ratio in the third semiconductor layer 33. The third semiconductor layer 33 has a layer 62 which has a thickness smaller than that of the second semiconductor layer 32 and has the same composition as that of the second semiconductor layer at a position away from the second semiconductor layer 32. The Al composition ratio decreases by a step of 25% from the second semiconductor layer 32 toward the first semiconductor layer 31. The third semiconductor layer 33 includes an AlN layer having a thickness of, for example, about 1 nm in the middle of the corresponding semiconductor layer. The third semiconductor layer 33 may have a plurality of the layers 62 with a constant interval therebetween. For example, the third semiconductor layer 33 has the layer 62 at the boarder of each step. When the third semiconductor layer 33 is configured in this way, it is also possible to reduce the dislocation density of the semiconductor device 100.

Fig. 10 illustrates another example of a change in the Al composition ratio in the third semiconductor layer 33. The third semiconductor layer 33 has a layer 64 which has a thicknesses smaller than that of the second semiconductor layer 32 and has the same composition as that of the first semiconductor layer at a position away from the second semiconductor layer 32. The Al composition ratio decreases by a step of 25% from the second semiconductor layer 32 toward the first semiconductor layer 31. The third semiconductor layer 33 includes an GaN layer having a thickness of, for example, about 1 nm in the middle of the corresponding semiconductor layer. The third semiconductor layer 33 may have a plurality of the layers 64 with a constant interval therebetween. For example, the third semiconductor layer 33 has the layer 64 at the boarder of each step. When the third semiconductor layer 33 is configured in this way, it is also possible to reduce the dislocation density of the semiconductor device 100.

The third semiconductor layer 33 may have a semiconductor layer having a smaller thickness than that of the second semiconductor layer and has a composition different from the adjacent layer at least one of at the interface with the second semiconductor layer 32 and the interface with the first semiconductor layer 31. The third semiconductor layer 33 may have a GaN layer that has a thickness of about 1 nm at the interface with the second semiconductor layer 32. The third semiconductor layer 33 may have an AlN layer that has a thickness of about 1 nm at the interface with the first semiconductor layer 31. In this way, it is possible to improve the crystallinity of the surface of the composite layer in the buffer region 30 and consequently the flatness of the surface, while the dislocation density is reduced.

A method of manufacturing the semiconductor device 100 will be now described. The method of manufacturing the semiconductor 100 includes providing the substrate 10, forming the interlayer 20 on the substrate 10, forming the buffer region 30 on the interlayer 20 and over the substrate 10, forming the active layer 70 on the buffer region 30, and forming at least two electrodes (72, 74, 76) on the active layer 70.

Providing the substrate 10 may include providing an Si (111) substrate or an Si (110) substrate which is fabricated through a CZ method. Forming the interlayer 20 may include maintaining the substrate temperature between 1000°C and 1100°C and epitaxially growing AlN to a thickness of about 40 nm on the main plane of the substrate 10 by a Metal Organic Chemical Vapor Deposition (MOCVD) method using a TMA (trimethyl aluminum) gas and a NH3 gas. Although the epitaxial growth is performed by a MOCVD method in this example, it can also be performed by a MBE method or the like. In the hereunder examples, growth temperatures for growing layers may be equal to or higher than 900°C and equal to or less than 1300°C.

Forming the buffer region 30 includes repeating at least one cycle in which the first semiconductor layer 31 with the first lattice constant is formed, the second semiconductor layer 32 with the second lattice constant is formed, and the third semiconductor layer with the third lattice constant is then formed. The second lattice constant is different from the first lattice constant. The third lattice constant has a value between the first lattice constant and the second lattice constant. The first lattice constant may be smaller than the lattice constant of the substrate 10. The second lattice constant may be smaller than the first lattice constant.

Forming the first semiconductor layer 31 may include epitaxially growing GaN on the interlayer 20 by supplying a TMG (trimethyl gallium) gas and a NH3 gas after the interlayer 20 is formed. Forming the second semiconductor layer 32 may include, after the first semiconductor layer 31 has been formed, epitaxially growing AlN on the first semiconductor layer 31 by supplying a TMA gas and a NH3 gas to deposit AlN to a thickness of 60 nm.

Forming the third semiconductor layer 33 may include epitaxially growing AlGaN on the second semiconductor layer 32 by supplying a TMA gas, a TMG gas, and an NH3 gas to deposit AlGaN to a thickness of 60 nm. At this point, the third semiconductor layer 33 in which the Al composition ratio is inclined can be formed by adjusting the gas flow rate of the TMA gas to be gradually increased. The step of forming the buffer region 30 may repeat the cycle of these formation steps and may adjust the growth times to vary the thicknesses of the first semiconductor layers 31 or GaN to, for example, 70 nm, 90 nm, 120 nm, 150 nm, 190 nm, 240 nm, 300 nm, 370 nm, 470 nm, 600 nm, 790 nm, and 1040 nm.

Forming the active layer 70 includes forming the electron transit layer 50 and forming the electron supply layer 60 on the electron transit layer 50. Forming the electron transit layer 50 may include epitaxially growing GaN on the third semiconductor layer 33 that is the top layer of the buffer region 30 by supplying a TMG gas and an NH3 gas to deposit GaN to a thickness of 1200 nm. Forming the electron supply layer 60 may include epitaxially growing Si-doped AlGaN on the electron transit layer 50 by supplying a TMA gas, a TMG gas, an NH3 gas, and an SiH4 gas to deposit Si-doped AlGaN to a thickness of 25 nm.

Forming at least two electrodes (72, 74, 76) may include forming a silicon oxide film on the surface of the electron supply layer 60, forming openings for the electrodes, and forming the electrodes. Forming a silicon oxide film on the surface of the substrate 10 may include removing the substrate 10 out of an MOCVD apparatus, placing the substrate 10 within a plasma CVD apparatus, and then forming the silicon oxide film on the whole surface of the substrate 10. Forming openings for the electrodes may include forming openings for a source electrode and a drain electrode by performing photolithography and etching. Forming the electrodes may include depositing Ti and Al sequentially by electron beam evaporation, and then forming the source electrode 72 and the drain electrode 76 that are in ohmic contact with the electron supply layer 60 by a lift-off method. Forming openings for the electrodes may include forming the openings for an gate electrode by performing photolithography and etching. Forming the electrodes may includes depositing Pt and Au sequentially by electron beam evaporation, and then forming the gate electrode 74 that is in schottky contact with the electron supply layer 60 by a lift-off method.

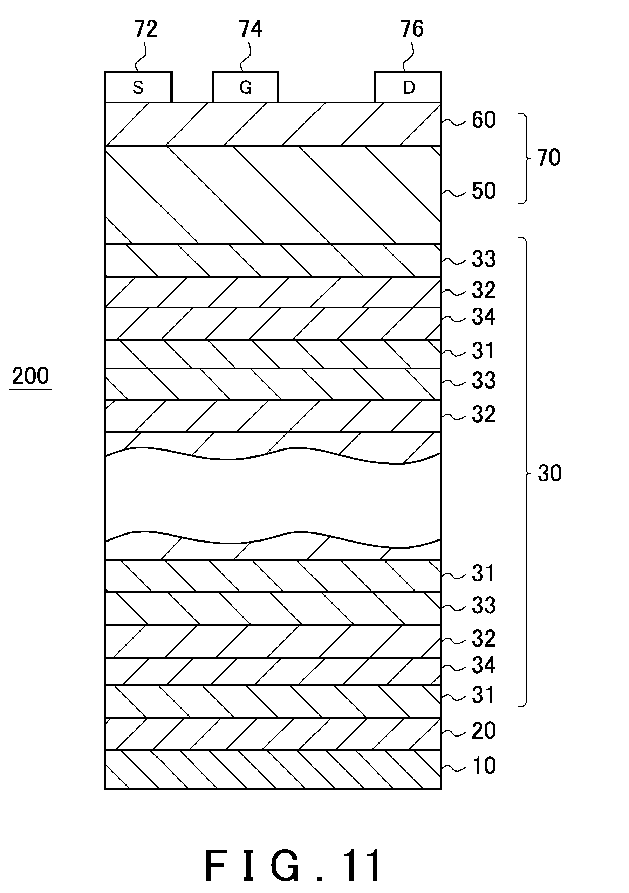

Fig. 11 is a sectional view of a semiconductor device 200 according to the second embodiment of the invention. The semiconductor device 200 has the buffer region 30 that has a different configuration from that of the semiconductor device 100. Configuration of the semiconductor device 200 may be same as the semiconductor device 100 except for the buffer region 30. The buffer region 30 of the semiconductor device 200 has a fourth semiconductor layer 34 with a fourth lattice constant formed between the first semiconductor layer 31 and the second semiconductor layer 32. The buffer region 30 includes at least one composite layer in which the first semiconductor layer 31, the fourth semiconductor layer 34, the second semiconductor layer 32, and the third semiconductor layer 33 are stacked in the stated order.

The fourth semiconductor layer 34 is formed on and in contact with the first semiconductor layer 31. The fourth semiconductor layer 34 has the fourth lattice constant that is between the first lattice constant and the second lattice constant. The fourth semiconductor layer 34 has a coefficient of thermal expansion between those of the first semiconductor layer 31 and the second semiconductor layer 32. The fourth semiconductor layer 34 includes Alₓ₄In_{y4}Ga₁-ₓ₄-_{y}4N (where 0 < x4 ≤ 1, 0 < y4 ≤ 1, x4+y4 ≤ 1). The fourth semiconductor layer 34 is made of, for example, AlGaN. The fourth semiconductor layer 34 has a lattice constant and a coefficient of thermal expansion that correspond to the Al composition ratio. The lattice constant of the fourth semiconductor layer 34 decreases from a point of the layer nearest to the substrate 10 to a point of the layer farthest from the substrate 10. In other words, the Al ratio in the fourth semiconductor layer 34 increases from the closest to the farthest to the substrate 10. The first to fourth semiconductor layers 31 to 34 have a relation in the Al composition, x1 ≤ x3, x4 ≤ x2.

The buffer region 30 relaxes strain generated from differences in the lattice constant and the coefficient of thermal expansion between the substrate 10 and the active layer 70, and restrains the threading dislocation density. At the same time, the buffer region 30 helps to reduce the leakage current in the semiconductor device 100. The buffer region 30 has, for example, twelve composite layers in which the first semiconductor layer 31, the fourth semiconductor layer 34, the second semiconductor layer 32, and the third semiconductor layer 33 are sequentially deposited. The thicknesses of the first semiconductor layers 31 in the composite layers are, for example, 10 nm, 30 nm, 60 nm, 90 nm, 100 nm, 180 nm, 240 nm, 310 nm, 410 nm, 540 nm, 730 nm, and 980 nm respectively stated from the one closest to the substrate 10. The thicknesses of the second semiconductor layers 32 may be constant and may be, for example, 60 nm. The thicknesses of the third semiconductor layers 33 may be constant and may be, for example, 60 nm. The thicknesses of the fourth semiconductor layers 34 may be constant and may be, for example, 60 nm.

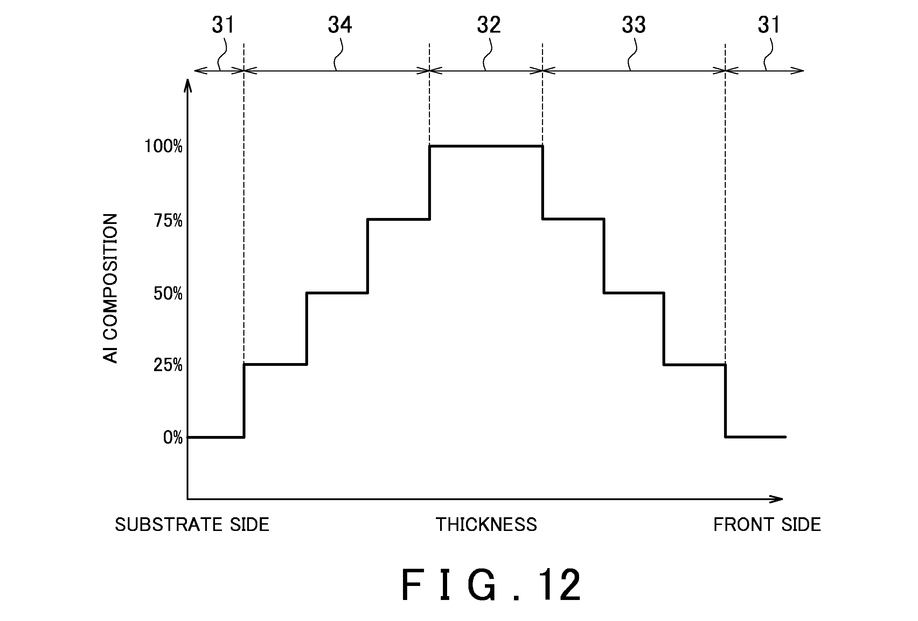

Fig. 12 illustrates a change in the Al composition ratio in the thickness direction of the buffer region 30. Here, the Al ratio in the first semiconductor layer 31 is 0%, and the Al ratio in the second semiconductor layer 32 is 100%. However, the Al ratios are not limited to this. The Al composition ratio in the fourth semiconductor layer 34 increases in a stepwise fashion from the first semiconductor layer 31 toward the second semiconductor layer 32. The Al composition ratio in the third semiconductor layer 33 decreases in a stepwise fashion from the second semiconductor layer 32 to the first semiconductor layer 31. For example, the Al composition ratio in the fourth semiconductor layer 34 increases by a step of 25% from the first semiconductor layer 31, and the Al composition ratio in the third semiconductor layer 33 decreases by a step of 25% from the second semiconductor layer 32. The thicknesses of the fourth semiconductor layer 34 and the third semiconductor layers 33 and are constant in each step, for example, the thickness is 20 nm, but it may be different for each step. The third semiconductor layer 33 and the fourth semiconductor layer 34 may be doped with an impurity. The impurity may be carbon C. The fourth semiconductor layer 34 and the third semiconductor layer 33 are doped with C at a concentration of, for example, 1E19 cm⁻³. Leakage current in the semiconductor device 100 can be reduced by doping the layers with C.

A silicon (111) substrate with a diameter of about 10 cm was used as the substrate 10, and the dislocation density was measured by X-ray diffractometry. The measurement result of the dislocation density of the semiconductor device 200 that has the buffer region 30 illustrated in Fig. 12 was formed was about 3E9 cm⁻². The dislocation density in the semiconductor device 200 was reduced compared to that of the semiconductor device 100.

A method of manufacturing the semiconductor device 200 according to the second embodiment of the invention will be now described. The method of manufacturing the semiconductor device 200 includes the same manufacturing steps as those of the semiconductor device 100 except for a step of forming the buffer region 30, and therefore the same steps will not be hereunder described. Forming the buffer region 30 includes at least one cycle in which the first semiconductor layer 31 with the first lattice constant is formed, the fourth semiconductor layer 34 with the fourth lattice constant is formed, the second semiconductor layer 32 with the second lattice constant is formed, and the third semiconductor layer 33 with the third lattice constant is formed in the stated order. The second lattice constant is different from the first lattice constant. The fourth lattice constant has a value between the first lattice constant and the second lattice constant. The third lattice constant has a value between the first lattice constant and the second lattice constant.

Forming the first semiconductor layer 31 may include epitaxially growing GaN on the interlayer 20 by supplying a TMG (trimethyl gallium) gas and a NH3 gas after the interlayer 20 is formed. Forming the fourth semiconductor layer 34 may include epitaxially growing AlGaN on the first semiconductor layer 31 by supplying a TMG gas, a TMA gas and an NH3 gas to deposit AlGaN to a thickness of 60 nm. At this point, the fourth semiconductor layer 34 in which the Al composition ratio is inclined can be formed by adjusting the gas flow rate of the TMA gas to be gradually increased.

Forming the second semiconductor layer 32 may include epitaxially growing AlN on the fourth semiconductor layer 34 by supplying a TMA gas and a NH3 gas to deposit AlN to a thickness of, for example, 60 nm. Forming the third semiconductor layer 33 may include epitaxially growing AlGaN on the second semiconductor layer 32 by supplying a TMG gas, a TMA gas, and a NH3 gas to deposit AlGaN to a thickness of, for example, 60 nm. At this point, the third semiconductor layer 33 in which the Al composition ratio is inclined can be formed by adjusting the gas flow rate of the TMA gas to be gradually decreased.

Forming the buffer region 30 includes repeating the cycle in which the first semiconductor layer 31 is formed, the fourth semiconductor layer 34 is formed, the second semiconductor layer 32 is formed, and the third semiconductor layer 33 is then formed. When one cycle is performed, a composite layer that includes the first semiconductor layer 31, the fourth semiconductor layer 34, the second semiconductor layer 32, and the third semiconductor layer 33 is formed. The thicknesses of the first semiconductor layers 31 in the composite layers are varied to, for example, 10 nm, 30 nm, 60 nm, 90 nm, 100 nm, 180 nm, 240 nm, 310 nm, 410 nm, 540 nm, 730 nm, and 980 nm, by adjusting the growth times.

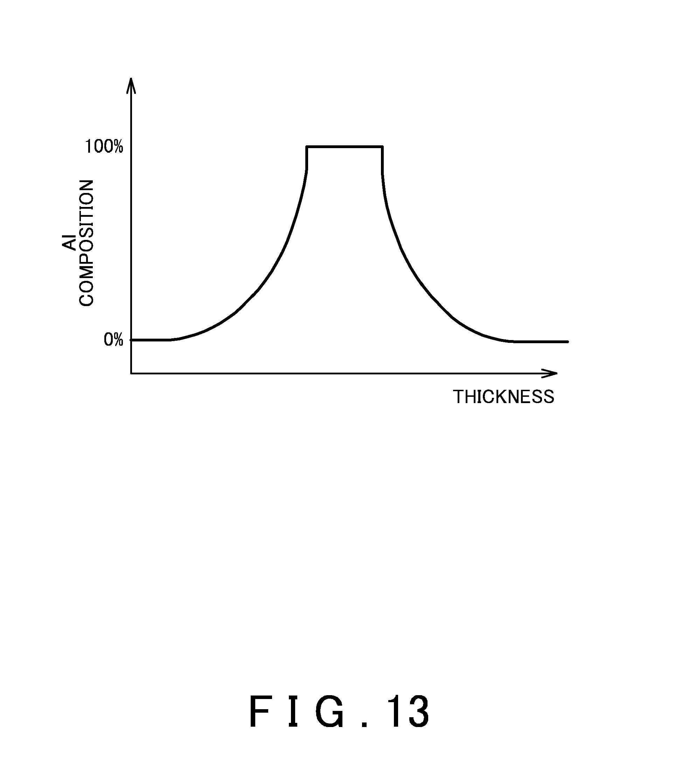

Fig. 13 illustrates another example of a change in the Al composition ratio in fourth and third semiconductor layers 34 and 33. The Al composition ratio in the fourth semiconductor layer 34 increases in a curved pattern from the first semiconductor layer 31 to the second semiconductor layer 32. The rate of increase of the Al composition ratio becomes larger as it gets closer to the second semiconductor layer 32. The Al composition ratio in the third semiconductor layer 33 decreases in a curved pattern from the second semiconductor layer 32 to the first semiconductor layer 31. The rate of decrease of the Al composition ratio becomes larger as it gets closer to the second semiconductor layer 32. When the fourth semiconductor layer 34 and the third semiconductor layer 33 are configured in this way, the dislocation density in the semiconductor device 200 is reduced compared with that of the semiconductor device 100.

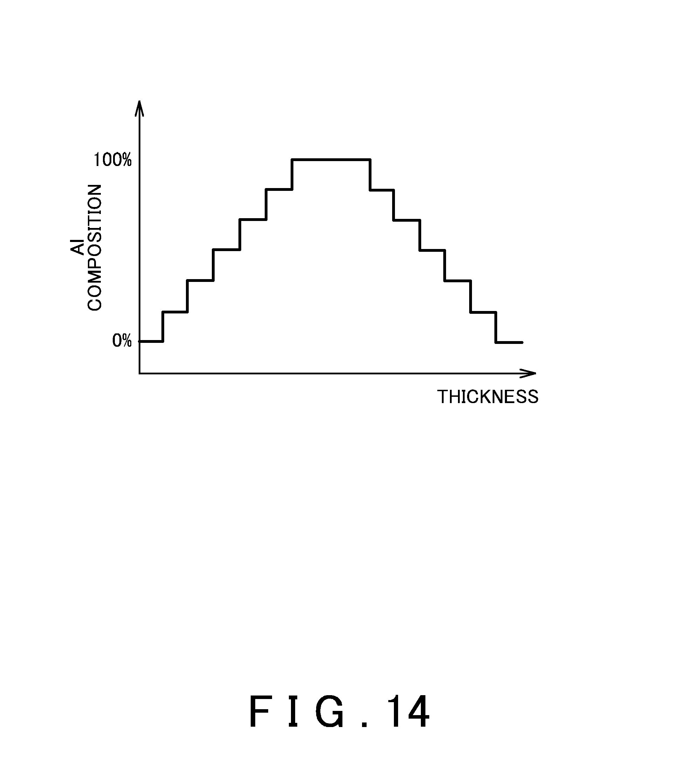

Fig. 14 illustrates another example of a change in the Al composition ratio in fourth and third semiconductor layers 34 and 33. The Al composition ratio in the fourth semiconductor layer 34 increases by a step of 5% from the first semiconductor layer 31 to the second semiconductor layer 32. The Al composition ratio in the third semiconductor layer 33 decreases by a step of 5% from the second semiconductor layer 32 to the first semiconductor layer 31. When the fourth semiconductor layer 34 and the third semiconductor layer 33 are configured in this way, the dislocation density in the semiconductor device 200 is reduced compared with that of the semiconductor device 100.

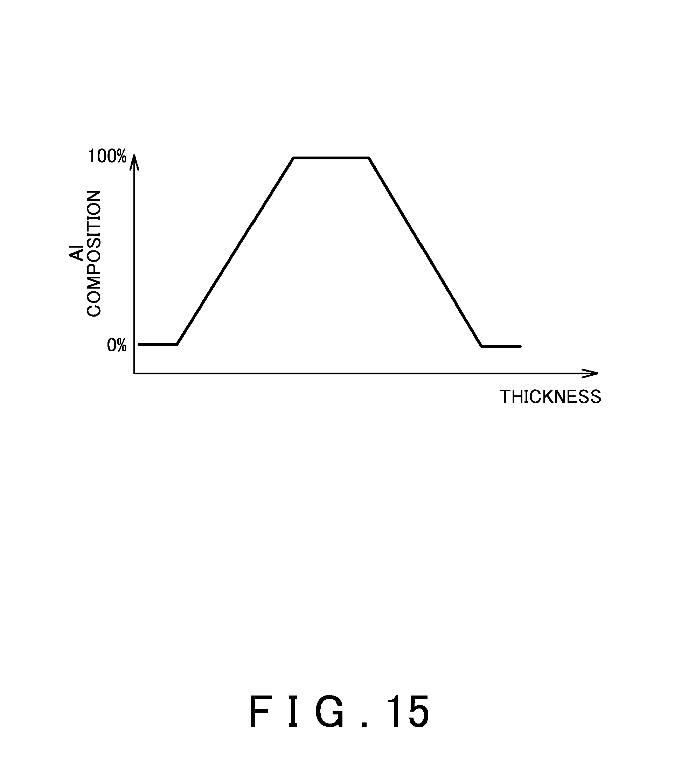

Fig. 15 illustrates another example of a change in the Al composition ratio in fourth and third semiconductor layers 34 and 33. The Al composition ratio in the fourth semiconductor layer 34 lineally increases from the first semiconductor layer 31 to the second semiconductor layer 32. The Al composition ratio in the third semiconductor layer 33 linearly decreases from the second semiconductor layer 32 to the first semiconductor layer 31. When the fourth semiconductor layer 34 and the third semiconductor layer 33 are configured in this way, the dislocation density in the semiconductor device 200 is reduced compared with that of the semiconductor device 100.

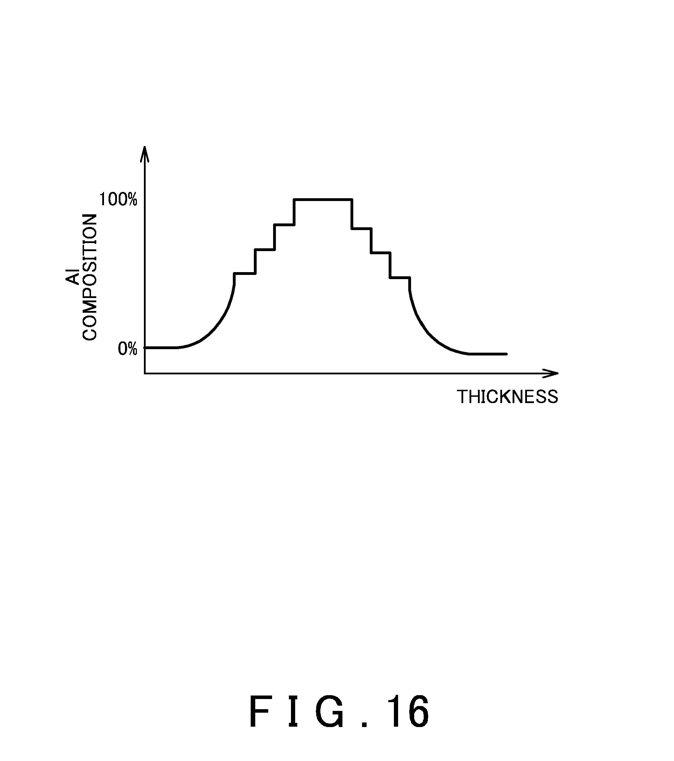

Fig. 16 illustrates another example of a change in the Al composition ratio in fourth and third semiconductor layers 34 and 33. The Al composition ratio in the fourth semiconductor layer 34 increases in a curved pattern from the first semiconductor layer 31 to the half way to the second semiconductor layer 32, then increases in a stepwise fashion. The rate of increase of the Al composition ratio becomes larger as it gets closer to the second semiconductor layer 32. The Al composition ratio in the third semiconductor layer 33 decreases in a stepwise fashion from the second semiconductor layer 32 to the half way to the first semiconductor layer 31, then decreases in a curved pattern. The rate of decrease of the Al composition ratio becomes larger as it gets closer to the second semiconductor layer 32. When the fourth semiconductor layer 34 and the third semiconductor layer 33 are configured in this way, the dislocation density in the semiconductor device 200 is reduced compared with that of the semiconductor device 100.

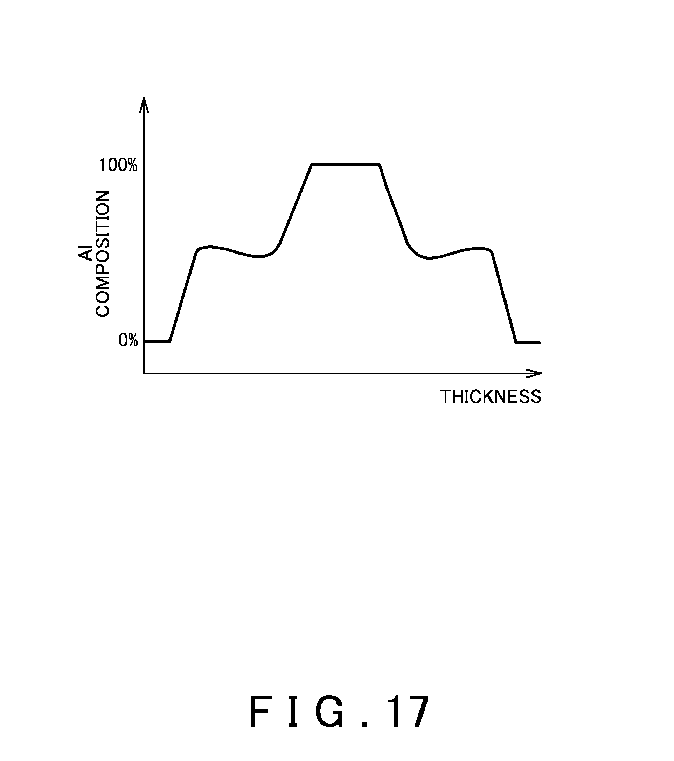

Fig. 17 illustrates another example of a change in the Al composition ratio in fourth and third semiconductor layers 34 and 33. The Al composition ratio in the fourth semiconductor layer 34 linearly increases from the first semiconductor layer 31 to the half way to the second semiconductor layer 32, then once decreases and increases linearly again. The Al composition ratio in the third semiconductor layer 33 linearly decreases from the second semiconductor layer 32 to the half way to the first semiconductor layer 31, then once increases and decreases linearly again. When the fourth semiconductor layer 34 and the third semiconductor layer 33 are configured in this way, the dislocation density in the semiconductor device 200 is reduced compared with that of the semiconductor device 100.

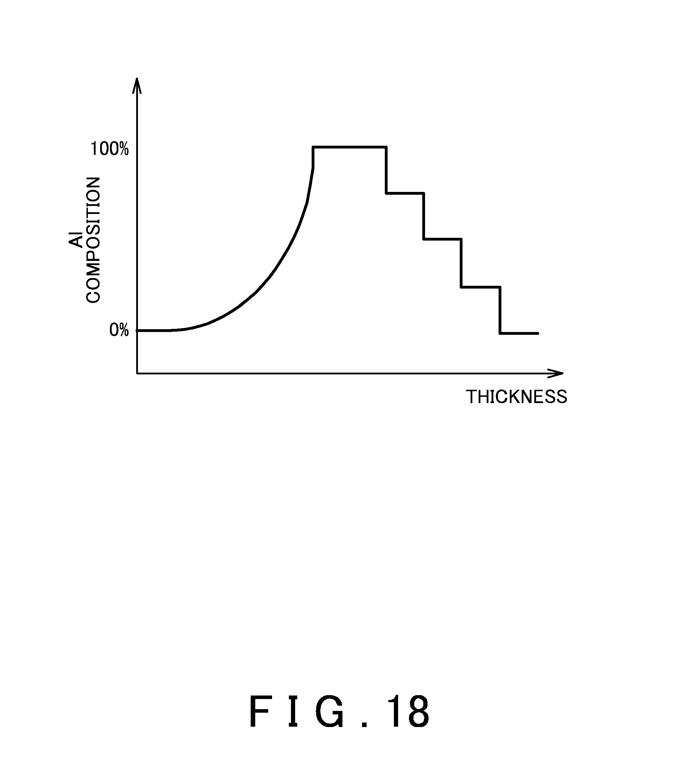

Fig. 18 illustrates another example of a change in the Al composition ratio in fourth and third semiconductor layers 34 and 33. The Al composition ratio in the fourth semiconductor layer 34 increases in a curved pattern from the first semiconductor layer 31 to the second semiconductor layer 32. The rate of increase of the Al composition ratio becomes larger as it gets closer to the second semiconductor layer 32. The Al composition ratio in the third semiconductor layer 33 decreases by a step of 25% from the second semiconductor layer 32 toward the first semiconductor layer 31. When the fourth semiconductor layer 34 and the third semiconductor layer 33 are configured in this way, the dislocation density in the semiconductor device 200 is reduced compared with that of the semiconductor device 100.

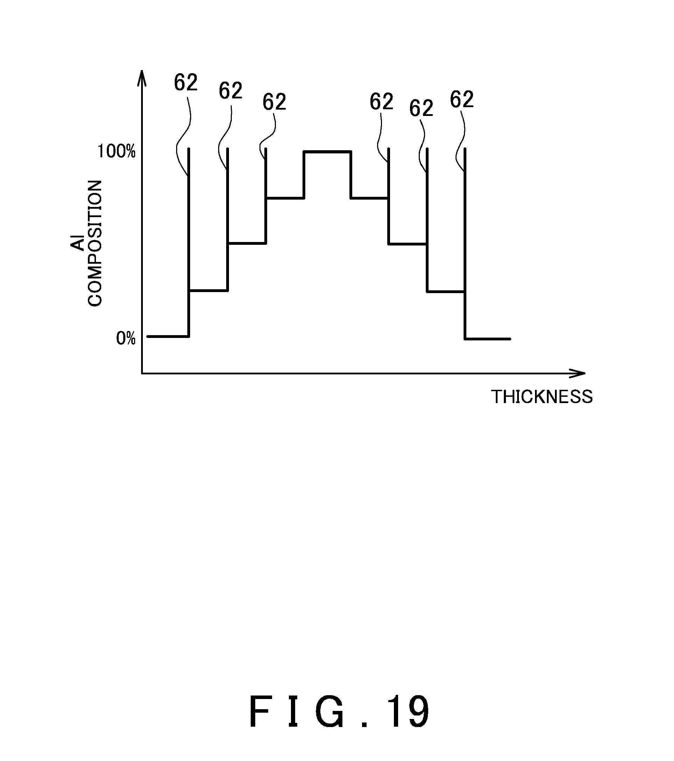

Fig. 19 illustrates another example of a change in the Al composition ratio in fourth and third semiconductor layers 34 and 33. The Al composition ratio in the fourth semiconductor layer 34 increases by a step of 25% from the first semiconductor layer 31 to the second semiconductor layer 32. The Al composition ratio in the third semiconductor layer 33 decreases by a step of 25% from the second semiconductor layer 32 to the first semiconductor layer 31. The fourth semiconductor layer 34 and the third semiconductor layer 33 may have a plurality of the layers 62 with a constant interval therebetween. The fourth semiconductor layer 34 and the third semiconductor layer 33 may have an AlN layer that has a thickness of 1 nm at the boarder of each step. In this way, it is possible to accommodate the warpage of the whole substrate. When the fourth semiconductor layer 34 and the third semiconductor layer 33 are configured in this way, the dislocation density in the semiconductor device 200 is reduced compared with that of the semiconductor device 100.

Fig. 20 illustrates another example of a change in the Al composition ratio in fourth and third semiconductor layers 34 and 33. The Al composition ratio in the fourth semiconductor layer 34 increases by a step of 25% from the first semiconductor layer 31 to the second semiconductor layer 32. The Al composition ratio in the third semiconductor layer 33 decreases by a step of 25% from the second semiconductor layer 32 to the first semiconductor layer 31. The fourth semiconductor layer 34 and the third semiconductor layer 33 may have a plurality of the layers 64 with a constant interval therebetween. The fourth semiconductor layer 34 and the third semiconductor layer 33 may have a GaN layer that has a thickness of 1 nm at the boarder of each step. In this way, it is possible to improve the crystallinity of the surface of the buffer region 30. When the fourth semiconductor layer 34 and the third semiconductor layer 33 are configured in this way, the dislocation density in the semiconductor device 200 is reduced compared with that of the semiconductor device 100.

The fourth semiconductor layer 34 may have a semiconductor layer that has a smaller thickness than that of the second semiconductor layer 32 at the interface with at least one of the first semiconductor layer 31 and the second semiconductor layer 32. This semiconductor layer has a different composition from a layer adjacent to the fourth semiconductor layer 34. The third semiconductor layer 33 may have a semiconductor layer that has a smaller thickness than that of the second semiconductor layer 32 at the interface with at least one of the second semiconductor layer 32 and the first semiconductor layer 31. This semiconductor layer has a different composition from a layer adjacent to the third semiconductor layer 33.

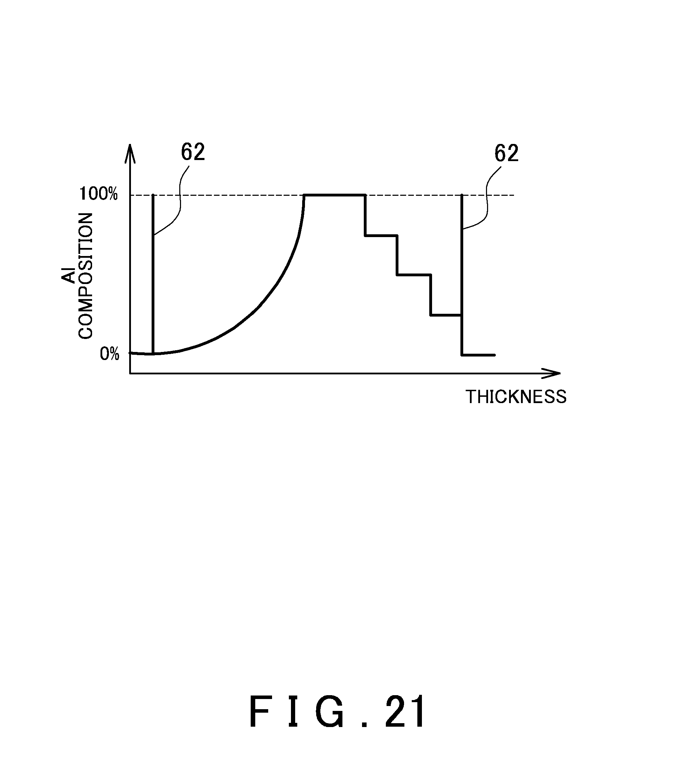

Fig. 21 illustrates another example of a change in the Al composition ratio in the case where the layer 62 that has a smaller thickness than that of the second semiconductor layer 32 is formed at the interface between the first semiconductor layer 31 and the fourth semiconductor layer 34 and at the interface between the third semiconductor layer 33 and the first semiconductor layer 31. The layer 62 may be an AlN layer that has a thickness of about 1 nm. In this way, the warpage of the whole substrate was controlled to the direction convex downward, and consequently the warpage of the whole wafer was eventually made zero. When the fourth semiconductor layer 34 and the third semiconductor layer 33 are configured in this way, the dislocation density in the semiconductor device 200 is reduced compared with that of the semiconductor device 100.

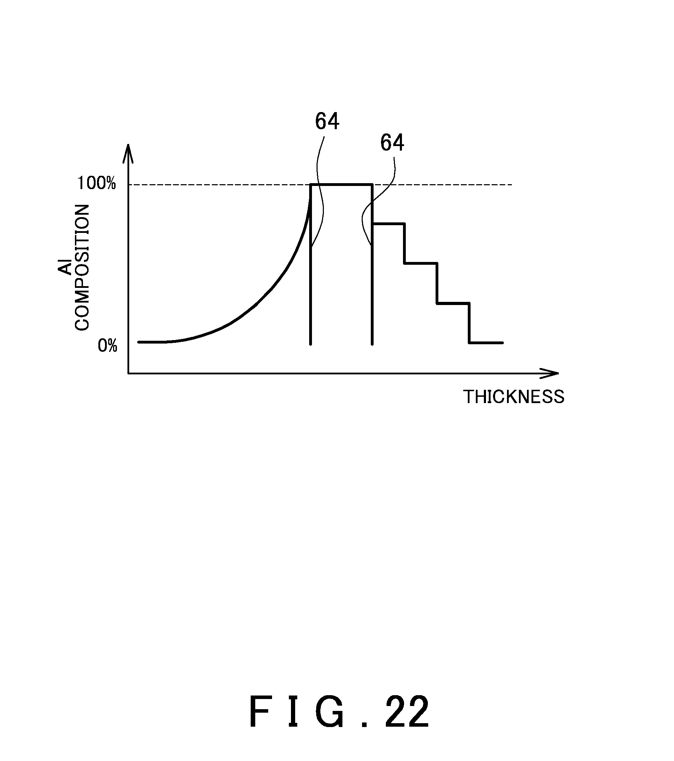

Fig. 22 illustrates another example of a change in the Al composition ratio in the case where the layer 64 that has a smaller thickness than that of the second semiconductor layer 32 is formed at the interface between the fourth semiconductor layer 34 and the second semiconductor layer 32 and at the interface between the second semiconductor layer 32 and the third semiconductor layer 33. The layer 64 may be a GaN layer that has a thickness of about 2 nm. In this way, it is possible to improve the crystallinity of the surface of the buffer region 30 and consequently the flatness of the surface can be obtained. When the fourth semiconductor layer 34 and the third semiconductor layer 33 are configured in this way, the dislocation density in the semiconductor device 200 is reduced compared with that of the semiconductor device 100.

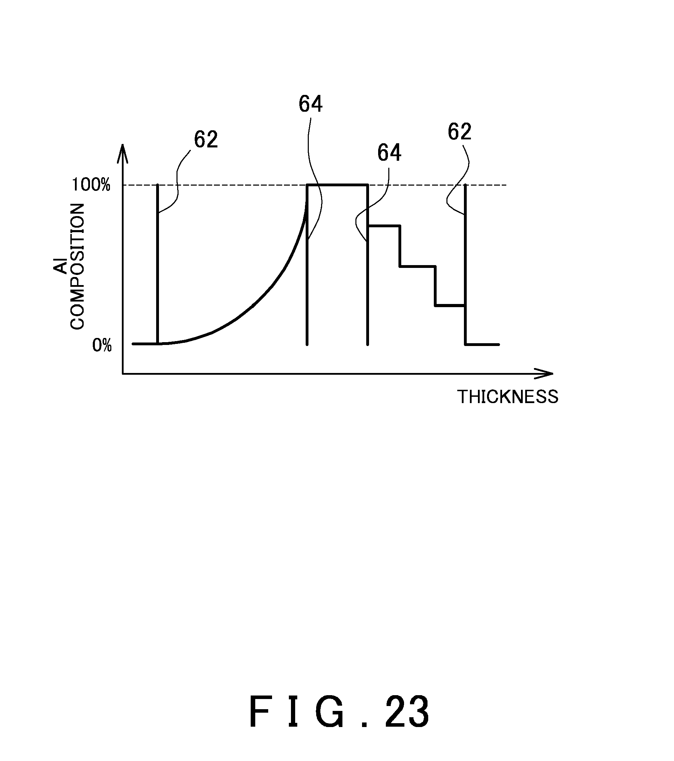

Fig. 23 illustrates another example of a change in the Al composition ratio in the case where the layer 62 or the layer 64 is formed at the interface between the fourth semiconductor layer 34 and an adjacent layer thereto and the interface between the third semiconductor layer 33 and an adjacent layer thereto. The fourth semiconductor layer 34 may have an AlN layer that has a thickness of about 0.2 nm at the interface with the first semiconductor layer 31. The fourth semiconductor layer 34 may have a GaN layer that has a thickness of about 0.2 nm at the interface with the second semiconductor layer 32. The third semiconductor layer 33 may have a GaN layer that has a thickness of about 0.2 nm at the interface with the second semiconductor layer 32. The third semiconductor layer 33 may have an AlN layer that has a thickness of about 0.2 nm at the interface with the first semiconductor layer 31. In this way, it is possible to improve the crystallinity of the surface of the buffer region 30 while warpage of the whole wafer is controlled. When the fourth semiconductor layer 34 and the third semiconductor layer 33 are configured in this way, the dislocation density in the semiconductor device 200 is reduced compared with that of the semiconductor device 100.

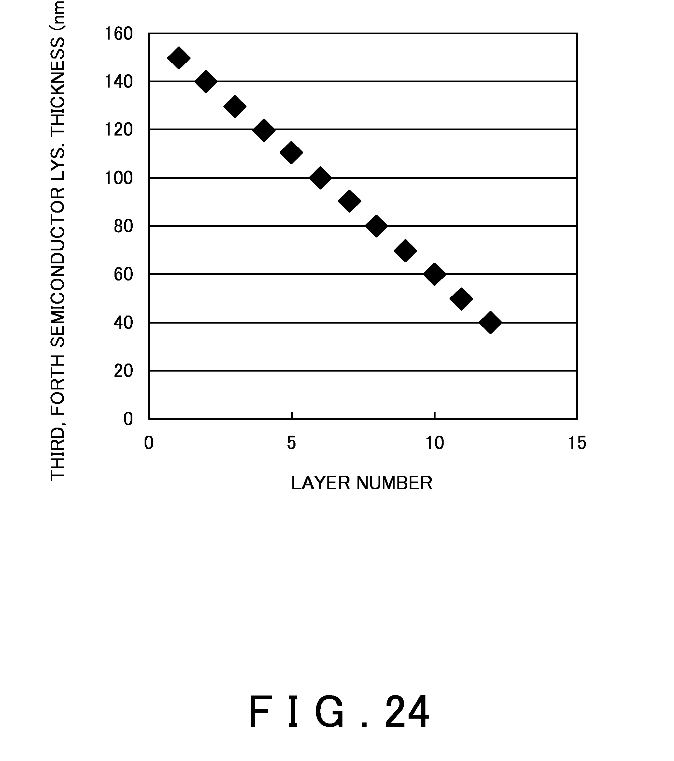

Fig. 24 illustrates the layer thicknesses of the third semiconductor layer 33 and the fourth semiconductor layer 34 in each composite layer in the buffer region 30. The horizontal axis in Fig. 24 shows the number of the composite layers from the first layer to the twelfth layer. The thicknesses of the third semiconductor layers 33 and the fourth semiconductor layers 34 decrease at a constant rate from the first layer to the twelfth layer. When the buffer region 30 is configured in this way, the dislocation density in the semiconductor device 200 is reduced compared with that of the semiconductor device 100.

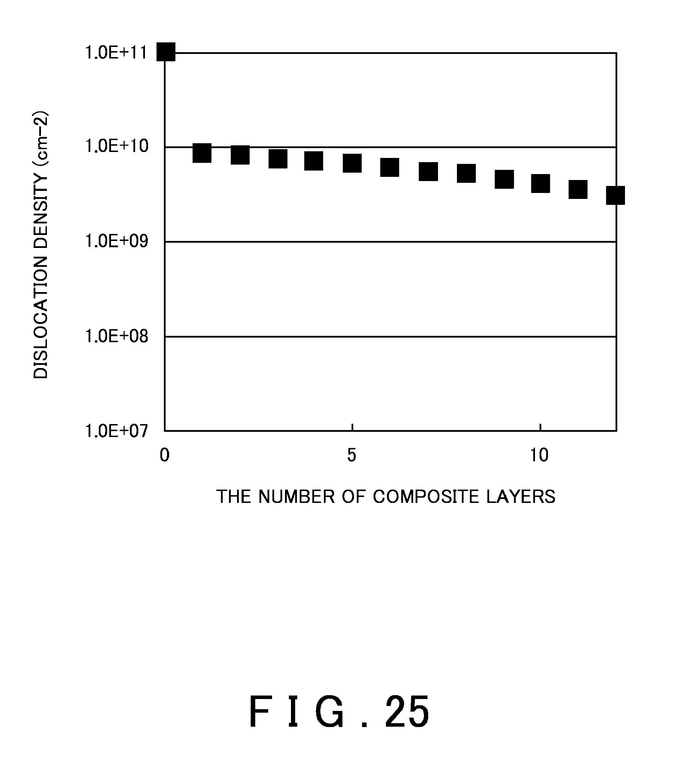

Fig. 25 illustrates relationship between a dislocation density and the number of composite layers. Measured were dislocation densities of the semiconductor elements 200 that have different numbers of the composite layers while the total thickness is maintained constant by changing the thickness of the first semiconductor layer 31. It was demonstrated from the measurements that the dislocation density was largely reduced even when only one composite layer was provided. Moreover, it was found that the larger the number of the composite layers was, more dislocation density was reduced.

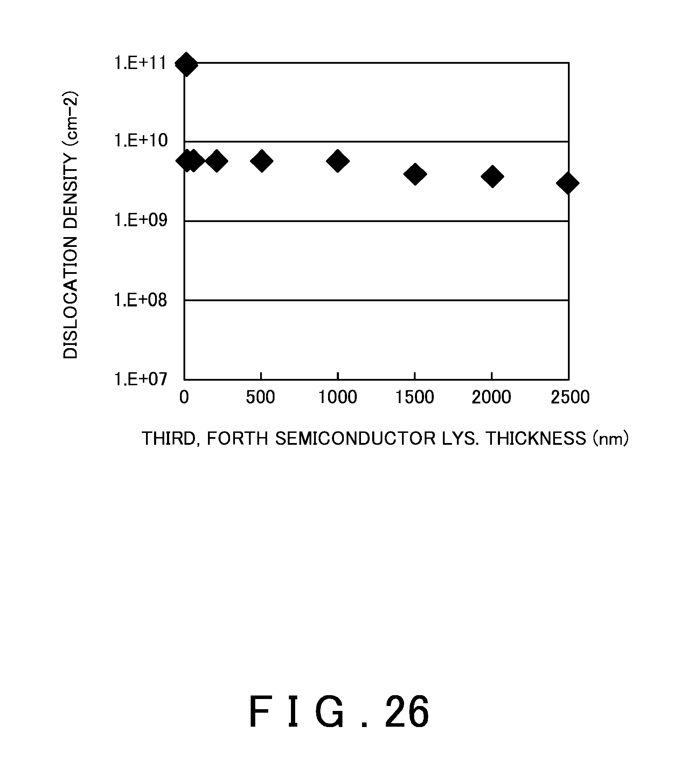

Fig. 26 illustrates relationships between a dislocation density and the thicknesses of the third semiconductor layer 33 and the fourth semiconductor layer 34 in the composite layer. The thickness of the first semiconductor layer 31 was controlled such that the total thickness of the buffer region 30 remains constant. When the thicknesses of the third semiconductor layer 33 and the fourth semiconductor layer 34 are less than 10 nm, the dislocation density is 1E11 cm⁻², which is not favorable. When the thicknesses of the third semiconductor layer 33 and the fourth semiconductor layer 34 are 10 nm or more, the dislocation density is 8E9 cm⁻² or less, which is favorable. Moreover, in terms of production efficiency, it is preferable that the thicknesses of the third semiconductor layer 33 and the fourth semiconductor layer 34 be 2500 nm or less. Thus, it is preferable that that the thicknesses of the third semiconductor layer 33 and the fourth semiconductor layer 34 be in a range from 10 nm to 2500 nm.

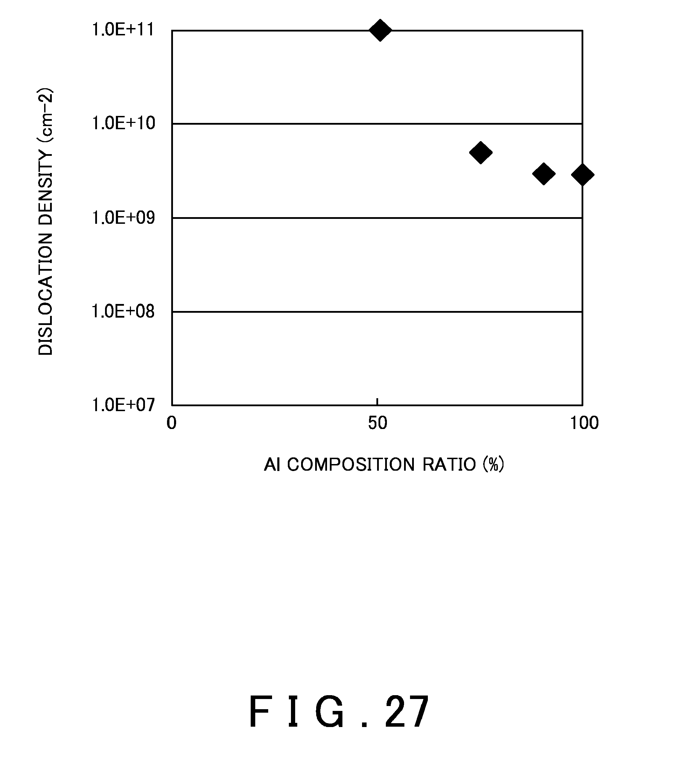

Fig. 27 illustrates relationships between the dislocation density and the largest Al composition ratios in the second semiconductor layer 32, the third semiconductor layer 33, and the fourth semiconductor layer 34. When the largest Al composition ratio in each layer is less than 75%, the dislocation density is 1E11 cm⁻², which is not favorable. When the largest Al composition ratio in each layer is 75% or more, the dislocation density is about 7E9 cm⁻² or less, which is favorable.

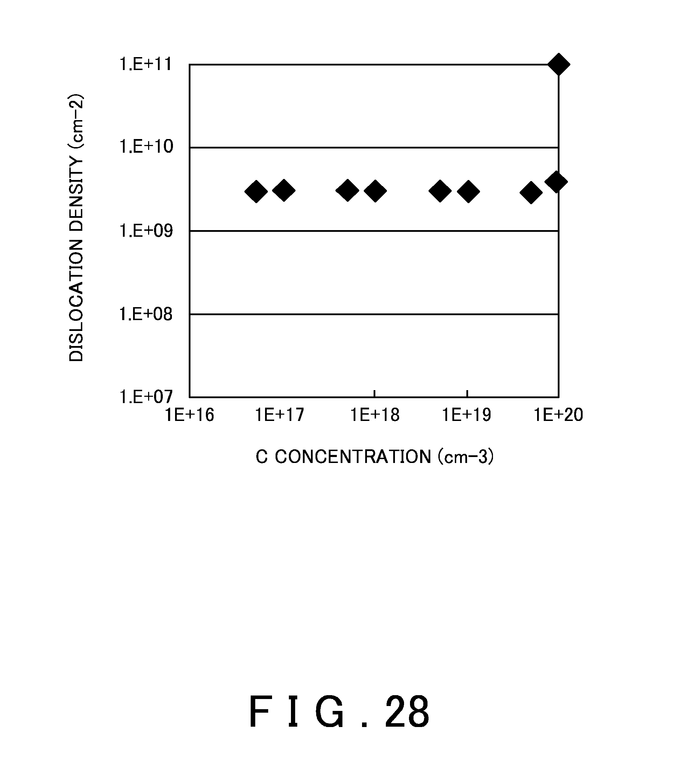

Fig. 28 illustrates relationship between the dislocation density and a C doping concentration in the second semiconductor layer 32. When the C doping concentration is no less than 1E17 cm⁻³ and no more than 9E19 cm⁻³, the dislocation density becomes preferably about 6E9 cm⁻² or less. When the C doping concentration is 9E19 cm⁻³ or more, the dislocation density unfavorably increases to 1E11 cm⁻². Thus, a preferable C doping concentration doped in the second semiconductor layer 32 is no less than 1E17 cm⁻³ and no more than 1E20 cm⁻³. Moreover, in order to reduce leakage current in the semiconductor device 200, it is preferable that the C doping concentration be more than 1E18 cm⁻³.

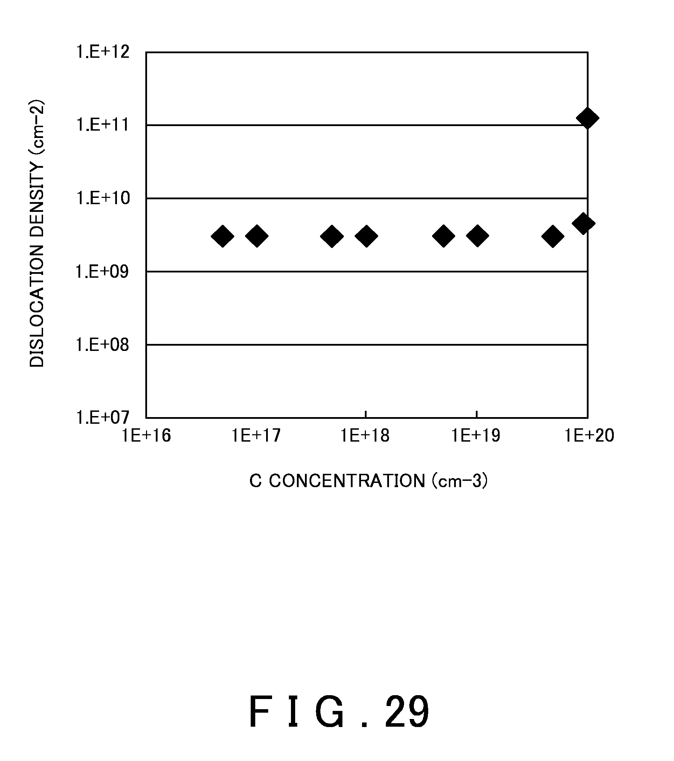

Fig. 29 illustrates relationship between the dislocation density and a C doping concentration in the first semiconductor layer 31. When the C doping concentration is no less than 1E18 cm⁻³ and no more than 9E19 cm⁻³, the dislocation density becomes preferably about 6E9 cm⁻² or less. When the C doping concentration is 9E19 cm⁻³ or more, the dislocation density unfavorably increases to about 2E11 cm⁻². Thus, a preferable C doping concentration doped in the first semiconductor layer 31 is no less than 1E18 cm⁻³ and no more than 1E20 cm⁻³. Moreover, in order to reduce leakage current in the semiconductor device 200, it is preferable that the C doping concentration be more than 1E18 cm⁻³.

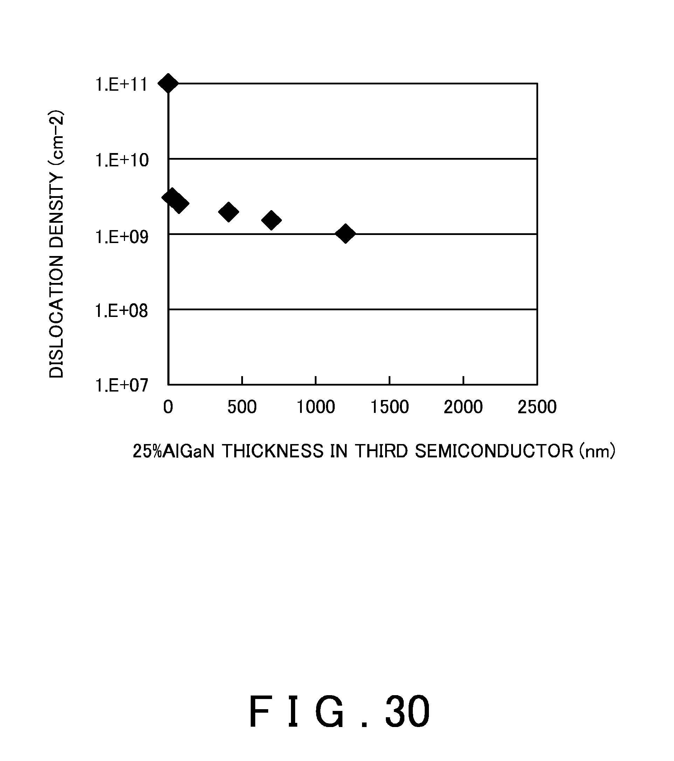

Fig. 30 illustrates relationship between the dislocation density and a layer thickness of an Al 25% region in the top third semiconductor layer 33 in the buffer region 30. When the layer thickness of the Al 25% region in the third semiconductor layer 33 is zero, the dislocation density is about 1E11 cm⁻², which is not favorable. When the layer thickness of the Al 25% region in the third semiconductor layer 33 is about 20 nm ore more, the dislocation density is about 5E9 cm⁻², which is favorable.

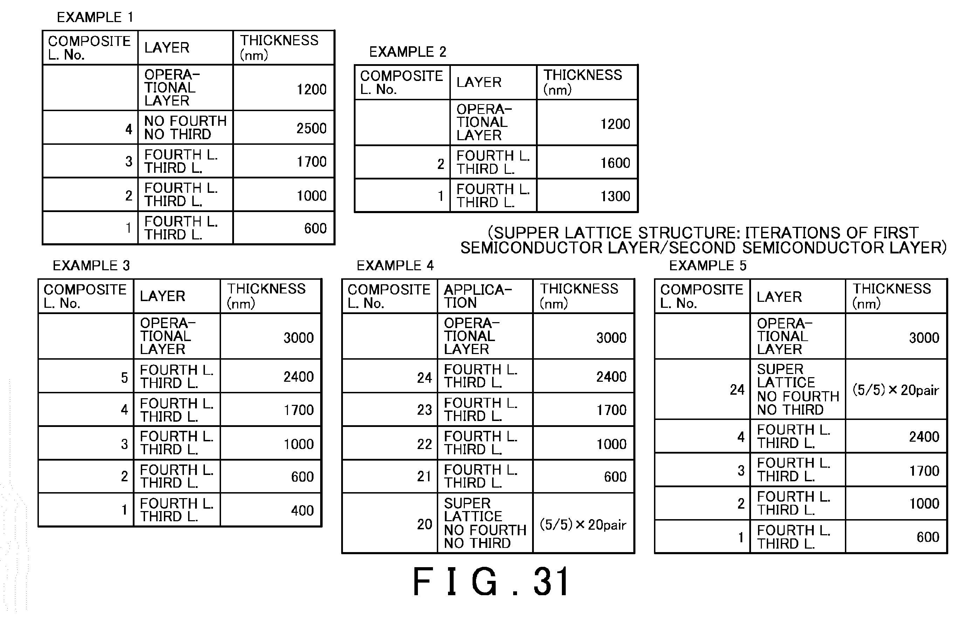

Fig. 31 illustrates Examples 1 to 5 in which the layer thickness of the first semiconductor layer 31 and the number of the composition layers in the buffer region 30 are varied. In each example, the number of the composition layer refers to the order of the composition layer which is arranged in the stack on the interlayer 20, and the thickness indicates the layer thickness of the first semiconductor layer 31 in the corresponding composition layer. The layer column indicates whether the corresponding composite layer includes the third semiconductor layer 33 or the fourth semiconductor layer 34. In Examples 1 to 5, the thickness of the first semiconductor layer 31 is 400 nm or more, and the thickness of the first semiconductor layer 31 in each composite layer increases gradually as the distance from the substrate 10 increases. In Example 5, twenty pairs of the first semiconductor layer 31 that has a thickness of 5 nm and the second semiconductor layer 32 that has a thickness of 5 nm form a superlattice structure.

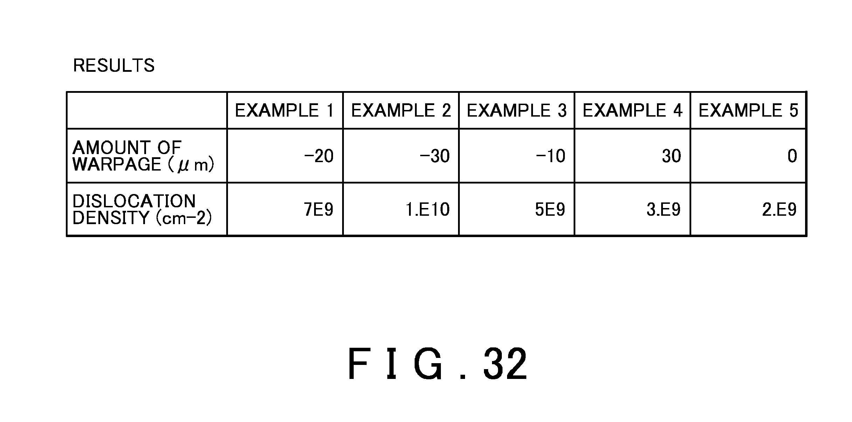

Fig. 32 illustrates measurement results of the amount of warpage and the leakage current in Examples 1 to 5. In each example, the dislocation density was reduced to 7E9 cm⁻² or less, and the amount of the warpage was accommodated in a range from +30 to -30. It is understood from the results of the measurements that it is preferable that the third semiconductor layer 33 and the fourth semiconductor layer 34 be provided, the thickness of the first semiconductor layer 31 in the buffer region 30 be 400 nm or more, and the thicknesses of the first semiconductor layers 31 be gradually increased as they are situated away from the substrate.

A thickness of the thickest layer among the first semiconductor layers 31 may be no less than 400 nm and no more than 3000 nm. It is preferable that the thickest layer among the first semiconductor layers 31 have a thickness of 400 nm or more in order to accommodate warpage. It is also preferable in terms of production efficiency that the thickest layer have a thickness of 3000 nm or less in order to shorten the growth time.

It is preferable that the thickness of the second semiconductor layer 32 be 0.5 nm or more in order to accommodate the warpage in the first semiconductor layer 31 to prevent crack. It is also preferable in terms of production efficiency that the second semiconductor layer 32 have a thickness of 200 nm or less in order to shorten the growth time.

It is preferable that the total thickness of the epitaxial layers including the buffer region 30 and the active layer 70 be 4 µm or more in order to curb the leakage current and to obtain a sufficient withstand voltage. The total number of the composition layers in the buffer region 30 may be any number no less than two, and it can be changed depending on the total thickness, the amount of warpage, a dislocation density and so on.

Although the HEMT-type field-effect transistor has been described as the semiconductor device, the semiconductor device is not limited to this but may be insulated gate field-effect transistors (MISFETs, MOSFETs), a Schottky gate field-effect transistors (MESFETs) and so on. Moreover, the features of the invention can also be applied to diodes in which a cathode electrode and an anode electrode are provided in stead of the source electrode 72, the gate electrode 74, and the drain electrode 76.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

As discussed above, according to the embodiments of the invention, it is possible to realize a semiconductor device with small warpage and small leakage current, and with which films of the device can be increased, and a method of manufacturing the same.

## Claims

1. A semiconductor device comprising:
a substrate;
a buffer region formed over the substrate;
an active layer formed on the buffer region; and
at least two electrodes formed on the active layer; wherein
the buffer region includes at least one composite layer in which a first semiconductor layer having a first lattice constant, a second semiconductor layer having a second lattice constant that is smaller than the first lattice constant and formed in contact with the first semiconductor layer, and a third semiconductor layer having a third lattice constant that is between the first lattice constant and the second lattice constant are sequentially stackedstacked on.

2. The semiconductor device according to claim 1, wherein
coefficients of thermal expansion of the first, second and third semiconductor layers are larger than a coefficient of thermal expansion of the substrate, and
the coefficient of thermal expansion of the third semiconductor layer has a value between the coefficient of thermal expansion of the first semiconductor layer and the coefficient of thermal expansion of the second semiconductor layer.

3. The semiconductor device according to claim 1 or 2, further comprising:
an interlayer that is disposed between the substrate and the buffer region, and that has a lattice constant smaller than the first lattice constant and a coefficient of thermal expansion larger than a coefficient of thermal expansion of the substrate.

4. The semiconductor device according to any one of claims 1 to 3, wherein
the first, second and third semiconductor layers include nitride-based compound semiconductor.

5. The semiconductor device according to any one of claims 1 to 4, wherein
the lattice constant of the third semiconductor layer increases from a side nearest to the substrate toward a side farthest from the substrate.

6. The semiconductor device according to any one of claims 1 to 5, wherein
the first lattice constant is smaller than a lattice constant of the substrate.

7. The semiconductor device according to any one of claims 1 to 6, wherein
the third semiconductor layer includes a layer that has a thickness smaller than a thickness of the second semiconductor layer, has a same composition as a composition of the first or second semiconductor layer, and is disposed at a position away from the second semiconductor layer.

8. The semiconductor device according to any one of claims 1 to 7, wherein
the third semiconductor layer has a layer that has a smaller thickness than a thickness of the second semiconductor layer at an interface with at least one of the second semiconductor layer and the first semiconductor layer, and the layer having a different composition than a composition of a layer that is in contact with the third semiconductor layer at the interface.

9. The semiconductor device according to any one of claims 1 to 8, wherein
the first semiconductor layer includes Alₓ₁In_{y1}Ga₁-ₓ₁-_{y1}N (where 0 < x1 < 1, 0 ≤ y1 ≤ 1, x1+y1 ≤ 1),
the second semiconductor layer includes Alₓ₂Iny₂Ga₁-ₓ₂-_{y2}N (where 0 < x2 ≤ 1, 0 ≤ y2 ≤ 1, x2+y2 ≤ 1),
the third semiconductor layer includes Alₓ₃In_{y3}Ga₁-ₓ₃-_{y3}N (where 0 < x3 < 1, 0 ≤ y3 ≤ 1, x3+y3 ≤ 1), and where x1 ≤ x3 ≤ x2, and
an Al ratio in the third semiconductor layer decreases from a side nearest to the substrate toward a side farthest from the substrate.

10. A method of manufacturing a semiconductor device, comprising:
providing a substrate;
forming a buffer region over the substrate;
forming an active layer on the buffer region; and
forming at least two electrodes on the active layer; wherein
the forming the buffer region includes repeating at least one cycle that includes forming a first semiconductor layer with a first lattice constant, forming a second semiconductor layer with a second lattice constant that is smaller than the first lattice constant in contact with the first semiconductor layer, and then forming a third semiconductor layer with a third lattice constant that is between the first lattice constant and the second lattice constant.
